(19) Europäisches Patentamt
European Patent Office
Office européen des brevets

(11) Veröffentlichungsnummer : **0 054 136**
**B1**

(12) # EUROPÄISCHE PATENTSCHRIFT

(45) Veröffentlichungstag der Patentschrift : **22.01.86**

(51) Int. Cl.⁴ : **C 08 G 79/14**, C 08 K 5/18, H 01 B 1/12, H 01 L 31/02, H 05 F 1/00

(21) Anmeldenummer : **81108695.8**

(22) Anmeldetag : **22.10.81**

(54) **Verfahren zur Herstellung von elektrisch leitfähigen Polymeren und deren Verwendung in der Elektrotechnik und zur antistatischen Ausrüstung von Kunststoffen.**

(30) Priorität : **13.12.80 DE 3047085**

(43) Veröffentlichungstag der Anmeldung : **23.06.82 Patentblatt 82/25**

(45) Bekanntmachung des Hinweises auf die Patenterteilung : **22.01.86 Patentblatt 86/04**

(84) Benannte Vertragsstaaten : **BE DE FR GB NL**

(56) Entgegenhaltungen :
**ANNALS OF THE NEW YORK ACADEMY OF SCIENCES, Band 313, 1978 New York P. DAY "Chemical Classification of Structures and Properties of Low-dimensional Inorganic Compounds" Seiten 9 bis 24**
**ANNALS OF THE NEW YORK ACADEMY OF SCIENCES, Band 313, 1978 New York T.J. MARKS "Rational Synthesis of New Unidimensional Solids: Chemical and Physical Studies Of Mixed-valence Polyiodides" Seiten 594 bis 616**
**Marks et al, Synthetic Metals 1, Seite 337-347 (1979/80)**
**Chemical Abstracts Band 80, Nr. 2 14. Januar 1974 Columbus, Ohio, USA R. ADERJAN et al. "Planar dicarbonylrhodium(I) and -iridium(I) complexes with polarizable aromatic ligands" Seite 471, Spalte 2, Abstarct Nr. 9919r**
**INORGANIC NUCLEAR CHEMISTRY LETTERS, Band 10, 1974 Oxford H. ENDRES et al. "Electrical Properties of Two Partially Oxidized Bis(1.2-Benzoquinonedioximato)Metal Complexes" Seiten 467 bis 471**
**NACHRICHTEN AUS CHEMIE, TECHNIK UND LABORATORIUM, Band 28, Nr. 9, 1980 Weinheim M. HANACK "Organische Leiter" Seiten 632 bis 636**

(73) Patentinhaber : **BASF Aktiengesellschaft**
**Carl-Bosch-Strasse 38**
***D-6700 Ludwigshafen (DE)***

(72) Erfinder : **Naarmann, Herbert, Dr.**
**Haardtblick 15**
**D-6719 Wattenheim (DE)**
Erfinder : **Penzien, Klaus, Dr.**
**Bensheimer Ring 18**
**D-6710 Frankenthal (DE)**
Erfinder : **Muench, Volker, Dr.**
**Luitpoldstrasse 114**
**D-6700 Ludwigshafen (DE)**
Erfinder : **Franz, Klaus-Dieter, Dr.**
**Budapester Strasse 45**
**D-6700 Ludwigshafen (DE)**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

EP 0 054 136 B1

**Beschreibung**

Die Erfindung betrifft ein Verfahren zur Herstellung von luftstabilen, elektrisch leitfähigen Polymeren mit elektrischen Leitfähigkeitswerten größer als $1 \times 10^{-3}$ S/cm durch Umsetzen eines Metallkations der Elemente der VII., VIII. oder I. Nebengruppe des Periodischen Systems mit einer zur Metallchelatbildung geeigneten organischen Verbindung zu Metallchelatkomplexen und deren Oxidation zu Polymeren.

Bei derartigen Verfahren zur Herstellung von Polymeren ist es erforderlich, Übergangsmetallkationen $Me^{n\oplus}$ mit einer zur Chelatbildung geeigneten organischen Verbindung zu Übergangsmetallchelatkomplexen mit quasi-eindimensionaler polymerer Struktur umzusetzen, bevor diese Chelatverbindungen oxidiert werden.

Es ist bereits bekannt, metallorganische Polymere mit direkter Metall-Metall-Wechselwirkung oder mit Metall-Ligang-Metall-Verknüfung in quasi-eindimensionale elektrisch leitfähige Polymere zu überführen (vgl. M. Hanack, Nachr. Chem. Tech. Lav. *28* (9) 632 (1980)).

Beispiele für bekannte Polymersysteme von Übergangsmetallkationen sind Tetracyanoplatinat (II) komplexe, welche in sogenannten Kolumnarstrukturen mit Pt-Pt-Kontakten kristallisieren (vgl. Angew. Chem., *81*, 10 (1964)). Durch partielle Oxidation dieser Komplexe entstehen gemischtvalente Polymere. Bekannt sind ferner bereits Übergangsmetallchelate mit Tetraazaporphinen, Phthalocyaninen, Dimethylglyoximen, Diphenylglyoximen, Dithioacetaten und anderen zur Metallchelatbildung geeigneten organischen Verbindungen (vgl. Annals of the New York Academy of Sciences, Synthesis and Properties of Low-Dimensional Materials, Edit. J. S. Miller and A. J. Epstein, Vol. 313, New York 1978, Seiten 9 ff, 25 ff, 594 ff und 633 ff).

Es ist weiterhin bekannt, daß zum Beispiel Bis(diphenylglyoximato) Ni (II) komplexe, welche eben gebaut sind und in Stapeln kristallisieren, durch Oxidation mit Iod in die elektrisch leitfähige Verbindung Bis(diphenylglyoximato) Ni. I überführt werden kann. Letztere weist gegenüber der Ausgangsverbindung einen Leitfähigkeitsantieg von $10^8$ auf $10^{-3}$ bis $10^{-2}$ S/cm auf (vgl. Inorg. Nucl. Chem. Lett., *10*, 467 (1974)). Bei Verbindungen dieses Typs bilden die Iodidanionen polymere Ketten, die in Kanälen zwischen den Komplexstapel in Stapelrichtung liegen und von den aromatischen Resten umgeben sind.

Weitere bekannte elektrisch leitfähige Polymere z. B. mit Iod oxidierte Polyacetylene, weisen den Nachteil auf, daß sie unter striktem Luftausschluß hergestellt und gehandhabt werden müssen. Sie nehmen bei Kontakt mit Luft sehr rasch Sauerstoff auf, wobei ihre Leitfähigkeiten um ein bis zwei Größenordnungen sinken.

Der Erfindung lag daher die Aufgabe zugrunde, neue einfache darzustellende elektrisch leitfähige Polymere mit elektrischen Leitfähigkeiten von über $1 \times 10^{-3}$ S/cm zu schaffen, die an der Luft stabil sind. Diese Polymere sollen Leitfähigkeiten von über $10^{-3}$ S/cm schon als Pulver und nicht erst als hochgeordnete Einkristalle aufweisen und dadurch die Verwendbarkeit und Anwendungsbreite in der Elektrotechnik deutlich verbessern.

Diese Aufgabe wurde erfindungsgemäß dadurch gelöst, daß man als zur Chelatbildung geeignete Verbindung ein 1,9-substituiertes Phenalen der allgemeinen Formel (I):

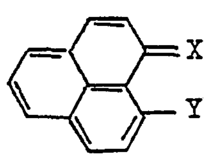

worin X = O, NH, Se oder Te und Y = OH, $NH_2$ oder SH, einsetzt.

Unter luftstabilen elektrisch leitfähigen Polymeren werden Polymere mit Leitfähigkeitswerten von größer als $1 \times 10^{-3}$ S/cm verstanden, welche sich in Luftatmosphäre bei Temperaturen von 0 bis 100 °C nicht zersetzen und stabil bleiben. Die elektrische Leitfähigkeitswerte werden in S/cm bei 30 °C gemessen, die Messung selbst erfolgt nach der Methode von F. Beck, Berichte Bunsengesellschaft, Physikalische Chemie *68*, 558-567 (1964).

Zur Herstellung der elektrisch leitfähigen Polymeren werden zunächst Metallkationen der Elemente der VII., VIII. oder I. Nebengruppe des Periodischen Systems mit einer zur Chelatbildung geeigneten organischen Verbindung zu Metallchelatkomplexen umgesetzt. Hierzu geht man von Metallkationen z. B. des Mn, Te, Re, Fe, Ru, Os, Co, Rh, Ir, Ni, Pd, Pt, Cu oder Mg, bevorzugt des Fe, Ni, Pd, Pt, Cu, aus, die in Form eines Salzes, z. B. des Halogenids, Halogenokomplexes, Sulfats, Nitrats, Phosphats, Perchlorats, Trifluormethansulfonats oder Acetats eingesetzt werden. Geeignete Salze dieser Art sind z. B. Manganacetat, Eisen (II) sulfat, Kobalt (II) acetat, Nickel (II) acetat, Palladium (II) chlorid oder Kaliumtetrachloroplatinat (II). Besonders gut geeignet ist Nickel (II) acetat. Die Umsetzung der Metallsalze mit der zur Chelatbildung geeigneten organischen Verbindung erfolgt bevorzugt in Lösung, besonders bevorzugt ist ein Ethanol-Wassergemisch im Volumenverhältnis 1 : 1, in dem man die Salze auflöst und die Lösung mit dem in Ethanol gelösten Chelatbildner mischt. Zur Beschleunigung der Umsetzung wird zweckmäßigerweise auf Siedetemperatur des Lösungsmittels, z. B. des Ethanol-Wasser-Gemisches, erhitzt. Nach diesem Herstellungsverfahren fällt das schwerlösliche metallorganische Polymere aus der Lösung aus und kann durch Umkristallisation aus einem höheren Alkohol, vorzugsweise aus n-Butanol, umkristallisiert und in wasserfreier Form isoliert werden. Nach besonders bevorzugter Verfahrensweise werden 1 Mol der zur Chelatbildung geeigneten organischen Verbindung in Ethanol gelöst vorgelegt und in der Siedehitze bei Temperaturen von 70 bis 80 °C ein halbes Mol Nickel (II) acetat in Ethanol/$H_2O$ = 1 : 1 dazugetropft. Dabei fallen in hoher Reinheit und Ausbeute die metallorganischen Chelatkomplexe aus.

Die Oxidation der metallorganischen Chelatkomplexe, die nach obiger Verfahrensweise hergestellt wurden, wird mit Hilfe von Oxidationsmitteln vorgenommen. Als geeignete Oxidationsmittel kommen in Frage : $AsF_5$, $SbF_5$, $SbCl_5$, Chlor, Brom und Iod, wobei Brom oder Iod bevorzugt und Iod besonders gut geeignet ist. Die Oxidation wird zweckmäßig in Gegenwart eines Lösungsmittels vorgenommen. Bevorzugt wird die Oxidation mit in chlorierten oder chlorfluorierten inerten Kohlenwasserstoffen gelöstem Iod in der Siedehitze durchgeführt, wobei sich die Polymeren bilden. Dazu werden die Chelatverbindungen mit einem 6- bis 10-fachen Überschuß an Iod, welches in chlorierten oder chlorfluorierten inerten Kohlenwasserstoffen gelöst ist, bei Temperaturen um + 40 bis + 100 °C mehrere Stunden bis Tage umgesetzt. Dabei fallen die luftstabilen, elektrisch leitfähigen polymeren Verbindungen aus. Zum Erreichen maximal hoher elektrischer Leitfähigkeiten wird bevorzugt die Oxidation unter Inertgasatmosphäre ausgeführt, wobei als Inertgas Argon verwendet wird.

Erfindungsgemäß werden als zur Chelatbildung geeignete organische Verbindungen 1,9-substituierte Phenalene (Perinaphthylene) der allgemeinen Formel (I) :

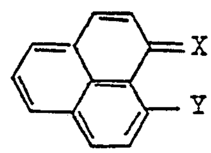

worin X = O, NH, S, Se oder Te und Y = OH, $NH_2$ oder SH, verwendet. Bevorzugt sind Verbindungen der Formel (I), in der X gleich O ist. Besonders bevorzugt is die organische Verbindung, bei der X = O und Y = $NH_2$, das 9-Amino-1-phenalenon.

Die erfindungsgemäß eingesetzten Verbindungen der Formel (I) sind an sich bekannt und in den Literaturstellen J. Org. Chem. *44*, (1979), 1704, Tetrahedron, *34*, (1978) 2174 und in GB-PS 1 388 417 beschrieben. Die Verbindungen (I) sind völlig eben gebaute, ungeradzahlige aromatische $C_{13}$-Kohlenwasserstoffe.

Bei der Umsetzung der Verbindungen (I) mit einem Metallkation der Elemente der VII., VIII. oder I. Nebengruppe des Periodischen Systems, bevorzugt mit den Kationen des Fe, Ni, Pd, Pt oder Cu, besonders bevorzugt des Ni, entstehen zunächst die Bis(chelat) metallkomplexe der allgemeinen Formel (II) :

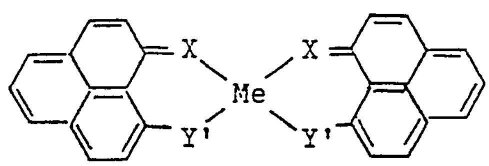 , (II)

worin X und Y die oben angegebene Bedeutung haben, Y' = Y weniger ein Wasserstoff und Me = Metall der eingangs definierten Art. Bei der Oxidation der Chelatverbindungen (II) entstehen dann die erfindungsgemäßen elektrisch leitfähigen Polymeren der allgemeinen Formel (III) .

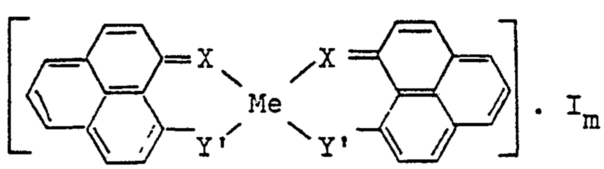 (III)

worin X, Y und Me die oben angegebene Bedeutung haben und m eine ganze Zahl zwischen 1 und 5 ist. Bevorzugte Verbindung (III) ist Bis(9-amino-1-phenalenonato) Ni · $I_{1-5}$.

Die unlöslichen, iodierten Polymere (III) werden durch Filtration von den Iodlösungen getrennt, mit chlorierten oder chlorfluorierten Kohlenwasserstoffen gewaschen und mehrere Stunden im Vakuum getrocknet.

Durch die genannten Arbeitsoperationen können elektrische Leitfähigkeitsanstiege von einigen Größenordnungen erreicht werden. Die Ausgangsleitfähigkeit der metallorganischen chelate (II) betrugen $10^{-12}$ S/cm. Die erfindungsgemäßen Polymeren (III) haben Leitfähigkeiten größer als $10^{-3}$ S/cm.

Die erfindungsgemäß hergestellten elektrisch leitfähigen polymeren Systeme mit elektrischen Leitfähigkeiten größer als $10^{-3}$ S/cm sind zur antistatischen Ausrüstung von Kunststoffen, zur Herstellung von Sonnenzellen, zur Umwandlung und Fixierung von Strahlung sowie zur Herstellung elektrischer und magnetischer Schalter geeignet. Durch die Zusätze der Oxidationsmittel entstehen sogenannte p-Leiter (vgl. « J. Chem. Education », *46* (1969), (2) Seite 82).

Beispiel

1. Herstellung von Bis(9-amino-1-phenalenonato) Ni (II)

0,1 mol 9-Amino-1-phenalenon wird in 700 ml Ethanol gelöst und zum Sieden erhitzt. In die siedende Lösung wird eine Lösung von 0,05 mol Ni (II)acetat · $4H_2O$ in 100 ml Ethanol/$H_2O$ = 1 : 1 eingetropft. Es bildet sich sofort das in Ethanol unlösliche Bis(9-amino-1-phenalenonato) Ni (II) · $2H_2O$. Man läßt noch 2 Stunden am Rückfluß kochen, isoliert die ausgefallene Substanz und entwässert sie im Vakuum bei 50 °C. Man erhält Bis(9-amino-1-phenalenonato) Ni (II) in 80-90 %iger Ausbeute als schwarzviolette Substanz. Die Leitfähigkeit der erhaltenen Substanz betrug $6{,}0 \cdot 10^{-13}$ S/cm.

2. Herstellung von Bis(9-amino-1-phenalenonato) Ni · $I_m$ (m = 1 bis 5)

1 g (2,23 mmol) Bis(9-amino-1-phenalenonato) Ni (II) und 3,35 g $I_2$ (= 13,2 mmol) werden in 220 ml $CCl_4$ 20 bis 30 Stunden am Rückfluß gekocht. Nach dem Abkühlen auf Zimmertemperatur trennt man das unlösliche Bis(4-amino-1-phenalenonato) Ni · $I_m$ (m = 1-5) ab, wäscht mit $CCl_4$ iodfrei und trocknet die Substanz bei 50 °C. Anschließend wird die Substanz ein Tag lang im Hochvakuum gepumpt.

Ausbeuten : 100 %, Leitfähigkeit : $1{,}3 \cdot 10^{-1}$ S/cm.

**Patentansprüche**

1. Verfahren zur Herstellung von luftstabilen, elektrisch leitfähigen Polymeren mit elektrischen Leitfähigkeitswerten größer als $1 \times 10^{-3}$ S/cm durch Umsetzen eines Metallkations der Elemente der VII., VIII. oder I. Nebengruppe des Periodischen Systems mit einer zur Metallchelatbildung geeigneten organischen Verbindung zu Metallchelatkomplexen und deren Oxidation zu Polymeren, dadurch gekennzeichnet, daß die zur Chelatbildung geeignete organische Verbindung ein 1,9-substituiertes Phenalen der allgemeinen Formel (I) :

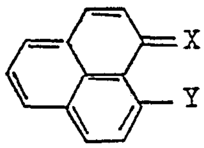

ist, worin X = O, NH, S, Se oder Te und Y = OH, $NH_2$ oder SH.

2. Verwendung der nach Anspruch 1 hergestellten elektrisch leitfähigen Polymeren in der Elektrotechnik zur Herstellung von Sonnenzellen, zur Umwandlung und Fixierung von Strahlung und zur Herstellung elektrischer und magnetischer Schalter.

3. Verwendung der nach Anspruch 1 hergestellten elektrisch leitfähigen Polymeren zur antistatischen Ausrüstung von Kunststoffen.

**Claims**

1. A process for the preparation of electrically conductive polymers which are stable to air and have conductivities greater than $1 \times 10^{-3}$ S/cm, by reacting a cation of a metal of group VII or VIII or of subgroup I of the periodic table with an organic chelating compound to give a metal chelate and oxidizing the latter to form a polymer, wherein the organic chelating compound is a 1,9-substituted phenalene of the general formula (I) :

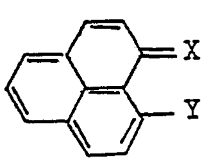

where X is O, NH, S, Se or Te and Y is OH, $NH_2$ or SH.

2. The use of the electrically conductive polymers prepared as claimed in claim 1 in electrical engineering for the production of solar cells, for the conversion and fixation of radiation, and for the production of electrical and magnetic switches.

3. The use of the electrically conductive polymers prepared as claimed in claim 1 for the antistatic treatment of plastics.

## Revendications

1. Procédé de préparation de polymères conducteurs de l'électricité, stables à l'air, possédant des conductibilités électriques supérieures à $1 \cdot 10^{-3}$ S/cm, par réaction d'un cation d'un métal du VII^e ou du VIII^e groupe ou du 1^er sous-groupe du Système périodique des Eléments avec une substance organique susceptible de former un complexe de métal, suivie de l'oxydation du complexe chélaté de métal formé en un polymère, caractérisé en ce que la substance organique convenant pour la chélation est un phénalène substitué sur les positions 1 et 9, de la formule générale (I)

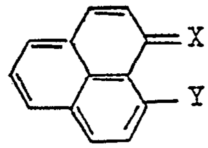

dans laquelle X = O, NH, S, Se ou Te et Y = OH, $NH_2$ ou SH.

2. Utilisation des polymères électro-conducteurs préparés par le procédé de la revendication 1 dans l'électrotechnique pour la fabrication de cellules solaires, pour la transformation et la fixation de radiations et pour la fabrication de commutateurs électriques et magnétiques.

3. Utilisation des polymères électro-conducteurs préparés par le procédé de la revendication 1 pour l'apprêtage antistatique de matières plastiques.